# EUROPÄISCHE PATENTSCHRIFT

(11) **EP 2 735 098 B1**
(45) Veröffentlichungstag und Bekanntmachung des Hinweises auf die Patenterteilung: **17.03.2021**
(21) Anmeldenummer: 12735858.8
(22) Anmeldetag: 12.07.2012
(51) Int. Cl.: H03K 17/082

(54) **SCHALTUNGSANORDNUNG ZUM SCHALTEN EINES STROMES UND VERFAHREN ZUM BETREIBEN EINES HALBLEITER-LEISTUNGSSCHALTERS**
CIRCUIT ARRANGEMENT FOR SWITCHING A CURRENT, AND METHOD FOR OPERATING A SEMICONDUCTOR CIRCUIT BREAKER
CIRCUIT DE COMMUTATION D'UN COURANT ET PROCÉDÉ PERMETTANT DE FAIRE FONCTIONNER UN INTERRUPTEUR DE PUISSANCE À SEMI-CONDUCTEUR

(30) Priorität: 21.07.2011 DE 102011079552
(43) Veröffentlichungstag der Anmeldung: 28.05.2014
(73) Patentinhaber: Siemens Aktiengesellschaft, 80333 München (DE)
(72) Erfinder: GEDIGA, Swen, 91315 Höchstadt/Aisch (DE); HANDT, Karsten, 90559 Burgthann (DE); SOMMER, Rainer, 91336 Heroldsbach (DE)
(86) Internationale Anmeldenummer: PCT/EP2012/063648
(87) Internationale Veröffentlichungsnummer: WO 2013/010898

(56) Entgegenhaltungen:
- EP-A2- 0 600 751
- WO-A1-2008/032113
- DE-A1-102004 020 273
- US-A1- 2005 099 751
- US-A1- 2008 232 144

## Beschreibung

Die Erfindung betrifft eine Schaltungsanordnung zum Schalten eines Stromes in Abhängigkeit von einem vorgegebenen Schaltsignal. Die Schaltungsanordnung umfasst einen Halbleiter-Leistungsschalter zum Schalten eines Stromes sowie eine Ansteuereinrichtung für den Halbleiter-Leistungsschalter. Die Ansteuereinrichtung ist dazu ausgelegt, das Schaltsignal zu empfangen und in Abhängigkeit von dem empfangenen Schaltsignal an einem Steuereingang des Halbleiter-Leistungsschalters eine Steuerspannung zu erzeugen.

Eine Schaltungsanordnung dieser Art ist aus der WO 2008/032113 A1 bekannt. Eine solche Schaltungsanordnung kann z.B. in einem steuerbaren Umrichter bereitgestellt sein, wie er zum Betreiben einer Drehstrommaschine verwendet werden kann.

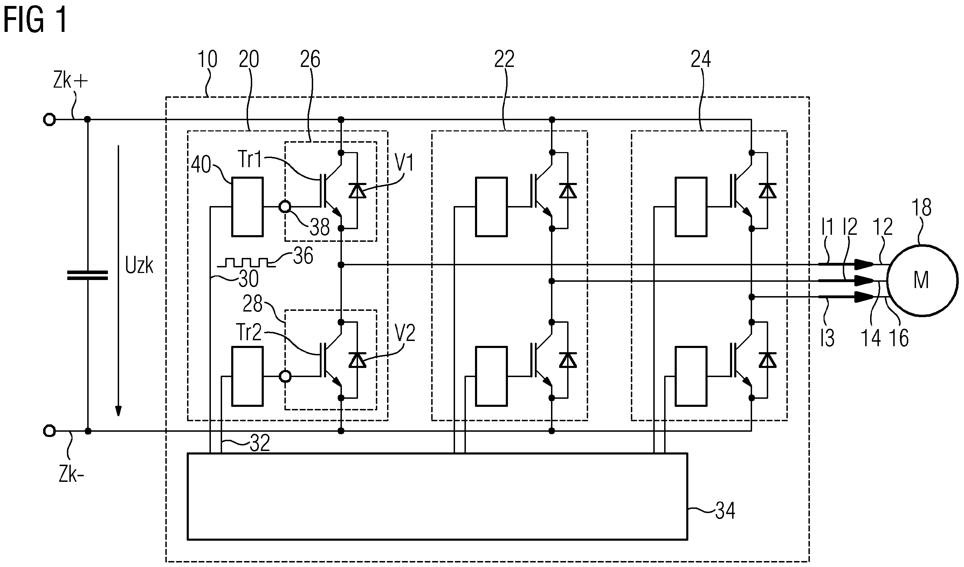

Die Funktionsweise eines steuerbaren Umrichters wird im Folgenden anhand von FIG 1 näher erläutert. Mittels eines Umrichters 10 können mit Hilfe einer Gleichspannung Uzk in Phasenleitern 12, 14, 16 Wechselströme I1, I2, I3 erzeugt werden, die zusammen einen Drehstrom bilden, mit dem eine elektrische Maschine 18 betrieben werden kann. Die Gleichspannung Uzk kann beispielsweise zwischen zwei Stromschienen ZK+, ZKeines Zwischenkreises eines Frequenzumrichters bereitgestellt sein. Zum Erzeugen der Wechselströme I1, I2, I3 sind die Phasenleiter 12, 14, 16 jeweils über eine Halbbrücke 20, 22, 24 mit den Stromschienen ZK+, ZK- in der in FIG 1 gezeigten Weise verbunden. Wie die Wechselströme I1, I2, I3 erzeugt werden, ist im Folgenden im Zusammenhang mit der Halbbrücke 20 erläutert. Entsprechendes gilt auch für die Wechselströme I2 und I3 in Verbindung mit den Halbbrücken 22 und 24.

Die Halbbrücke 20 weist zwei Halbleiter-Leistungsschalter 26, 28 auf, von denen jeder einen Transistor Tr1 bzw. Tr2 und eine diesem anti-parallel geschaltete Diode V1 bzw. V2 aufweist. Über die Halbleiter-Leistungsschalter 26, 28 ist der Phasenleiter 12 einmal mit der Plus-Stromschiene ZK+ und einmal mit der Minus-Stromschiene ZK- verschaltet. Bei den Transistoren Tr1, Tr2 kann es sich z.B. um IGBT (Insulated gate bipolar transistor) oder um MOSFET (Metal oxide semiconductor field effect transistor) handeln. Die Halbleiter-Leistungsschalter 26, 28 sind jeweils über eine Steuerleitung 30, 32 mit einer Steuereinheit 34 verbunden. Die Steuereinheit 34 erzeugt ein Taktsignal 36, welches über die Steuerleitung 30 zum Halbleiter-Leistungsschalter 26 übertragen wird. Durch das Taktsignal 36 wird der Transistor Tr1 des Halbleiter-Leistungsschalters 26 abwechselnd in einen leitenden und einen sperrenden Zustand geschaltet. Über die andere Steuerleitung 32 überträgt die Steuereinheit 34 ein Gegentaktsignal zum Halbleiter-Leistungsschalter 26, so dass der Transistor Tr2 des Halbleiter-Leistungsschalters 28 im Gegentakt zum Transistor Tr1 geschaltet wird. Das abwechselnde Schalten der Transistoren Tr1 und Tr2 erzeugt in dem Phasenleiter 12 eine Wechselspannung und damit den Wechselstrom I1. Zum Erzeugen des Drehstroms werden durch die Steuereinheit 34 entsprechend phasenversetzte Taktsignale über weitere Steuerleitungen an Leistungsschalter der übrigen Halbbrücken 22 und 24 übertragen. Mittels der Dioden der Halbleiter-Leistungsschalter ist es möglich, eine von der elektrischen Maschine 18 erzeugte Wechselspannung gleichzurichten.

Die von der Steuereinheit 34 erzeugten Taktsignale, wie das Taktsignal 36, sind in der Regel nicht in einer Form vorhanden, um damit einen Halbleiter-Leistungsschalter schalten zu können. Daher ist einem Steuereingang 38 des Halbleiter-Leistungsschalters 26 eine Ansteuerschaltung 40 vorgeschaltet, welche mittels einer (nicht näher dargestellten) Treiberschaltung in Abhängigkeit von dem Taktsignal 36 eine Steuerspannung an dem Steuereingang 38 erzeugt. Der Steuereingang 38 ist im Falle eines Transistors dessen Gate bzw. Basis. In gleicher Weise ist dem Halbleiter-Leistungsschalter 28 eine entsprechende Ansteuerschaltung und sind auch den Leistungsschaltern der Brücken 22 und 24 entsprechende Ansteuerschaltungen vorgeschaltet.

Beim Schalten eines Stromes mittels z.B. des Halbleiter-Leistungsschalters 26 muss beachtet werden, dass in Abhängigkeit davon, wie schnell der Halbleiter-Leistungsschalter 26 beispielsweise von einem leitenden in einen sperrenden Zustand überführt wird, durch (in FIG 1 nicht dargestellte) Induktivitäten des Schaltkreises eine Spannung induziert werden kann. Diese Induktionsspannung überlagert sich dann der Betriebsspannung, so dass sich am Halbleiter-Leistungsschalter 26 ein Wert der über diesem abfallenden Spannung ergeben kann, der über einem höchstens zulässigen Wert liegt. Hierdurch können dann Komponenten des Halbleiter-Leistungsschalters 26 beschädigt werden. Deshalb kann vorgesehen sein, dass durch die Ansteuerschaltung 40 zumindest bei Schaltflanken des Schaltsignals 36, durch die ein Sperren des Halbleiter-Leistungsschalters 26 bewirkt wird, eine Steuerspannung am Steuereingang 38 erzeugt wird, die einen im Verhältnis zu dem Verlauf des Schaltsignals 36 abgeflachten Verlauf aufweist.

Um eine Steuerspannung mit einem abgeflachten Verlauf zu erhalten, lehrt die Druckschrift WO 2008/032113 A1, einen durch den Leistungshalbleiter fließenden Strom zu messen und während eines Schaltvorgangs im zeitlichen Verlauf der Stromstärke eine Extremstelle (ein Maximum oder ein Minimum) zu ermitteln. Bis zum Erreichen der Extremstelle wird eine Steuerspannung am Steuereingang des Leistungshalbleiters nur langsam verändert, so dass sich ein rampenförmiger Verlauf der Steuerspannung ergibt und sich eine Leitfähigkeit des Leistungshalbleiters nur verhältnismäßig langsam ändert. Nach Erreichen der Extremstelle wird die Steuerspannung dann abrupt auf ihren Endwert geschaltet.

Nachteilig bei einer solchen Lösung ist, dass für die Zeitdauer, während welcher die Steuerspannung nur langsam mit einem rampenförmigen Verlauf abgesenkt wird, die Schaltverluste in dem Leistungshalbleiter sehr hoch sind.

In Dokument US 2005/0099751 A1 ist eine Treiberschaltung zum Schalten eines Halbleiter-Leistungsschalters in Abhängigkeit von einem Steuersignal beschrieben. Die Treiberschaltung weist eine Temperaturüberwachung auf, durch welche ein maximaler Strom durch den Leistungs-Halbleiterschalter immer dann begrenzt wird, wenn der Schalter zu heiß ist. Des Weiteren ist eine Schutzschaltung bereitgestellt, durch welche eine Stromstärke durch den Schalter gemessen wird und bei Erkennen eines Überstroms die Leitfähigkeit des Schalters reduziert wird.

In dem Dokument US 2008/0232144 A1 ist eine Vorladeschaltung zum kontrollierten Aufladen eines Glättungskondensators für einen Gleichspannungs-Zwischenkreis beschrieben. Durch die Schaltung wird eine Steigung eines zeitigen Verlaufs der Spannung in dem Zwischenkreis ermittelt. Steigt die Spannung zu schnell an, so wird ein in dem Zwischenkreis fließender Strom begrenzt.

In Dokument EP 0 600 751 A2 ist eine Treiberschaltung für einen Leistungs-Halbleiterschalter beschrieben, mittels welcher der Schalter dauerhaft in einen sperrenden Zustand geschaltet wird, wenn der Schalter zu heiß oder auf eine andere Weise überlastet ist. Bei der Treiberschaltung lässt sich eine Kennlinie einprogrammieren, die eine Reaktionszeit in Abhängigkeit von dem Wert, um welchen der jeweilige Grenzwert überschritten wird, festlegt.

In dem Dokument DE 10 2004 020 273 A1 ist eine Steuerung eines Betriebes eines Halbleiterschalters beschrieben. Es wird ein Zeitintervall, während welchem der Halbleiterschalter in einem Übergangszustand gehalten ist, in Abhängigkeit davon auf einen Maximalwert begrenzt, wie groß eine über dem Halbleiterschalter abfallende Spannung ist.

Es ist Aufgabe der vorliegenden Erfindung, bei einem Halbleiter-Leistungsschalter die Schaltverluste zu verringern.

Die Aufgabe wird durch eine Schaltungsanordnung gemäß Patentanspruch 1 und durch ein Verfahren gemäß Patentanspruch 7 gelöst. Vorteilhafte Weiterbildungen der erfindungsgemäßen Schaltungsanordnung und des erfindungsgemäßen Verfahrens sind durch die Unteransprüche gegeben.

Mit der erfindungsgemäßen Schaltungsanordnung kann ein Strom in Abhängigkeit von einem vorgebbaren Schaltsignal geschaltet werden. Die Schaltungsanordnung weist dazu eine Ansteuereinrichtung auf, die dazu ausgelegt ist, das Schaltsignal zu empfangen und in Abhängigkeit von dem empfangenen Schaltsignal einen Halbleiter-Leistungsschalter anzusteuern. Im Zusammenhang mit dem oben beschriebenen Umrichter könnte die Ansteuereinrichtung z.B. eine Ansteuerschaltung für den Halbleiter-Leistungsschalter bilden, die das Schaltsignal von dem Mikrocontroller empfängt.

Mit dem Halbleiter-Leistungsschalter kann ein Strom kontrolliert geschaltet werden. Um die Stromstärke des Stromes gemäß dem Schaltsignal zu verändern, erzeugt die Ansteuereinrichtung in Abhängigkeit von dem empfangenen Schaltsignal eine Steuerspannung an einem Steuereingang des Halbleiter-Leistungsschalters. Ein zeitlicher Verlauf der Steuerspannung wird dabei derart vorgegeben, dass während eines Schaltvorgangs wenigstens eine vorbestimmte Betriebsgröße des Halbleiter-Leistungsschalters, also z.B. eine Kollektor-Emitter-Spannung eines IGBT, ein vorbestimmtes Kriterium erfüllt. Es wird also nicht einfach abrupt und dauerhaft zwischen einem leitenden und einem sperrenden Zustand des Halbleiter-Leistungsschalters umgeschaltet. Stattdessen wird ein zeitlicher Verlauf der Betriebsgröße beim Übergang zwischen den beiden Schaltzuständen (leitend und sperrend) berücksichtigt und ein Schaltvorgang durch einen entsprechenden Verlauf der Steuerspannung z.B. verlängert, um eine Induktionsspannung gering zu halten.

Eine Betriebsgröße kann z. B. eine über einem Transistor und/oder einer Diode des Halbleiter-Leistungsschalters abfallende Spannung oder eine Steigung eines zeitlichen Verlaufs dieser Spannung sein. Genauso kann eine Steigung eines zeitlichen Verlaufs des zu schaltenden Stromes als Betriebsgröße beim Schalten berücksichtigt werden.

Als Kriterium für die Betriebgröße kann z.B. vorgegeben sein, dass die Betriebsgröße während des Schaltens einen bestimmten Sollwert annehmen soll. Genauso kann vorgegeben sein, dass die Betriebgröße einen bestimmten Grenzwert nicht über- bzw. unterschreiten soll.

Bei der erfindungsgemäßen Schaltungsanordnung ist das Kriterium, also z.B. ein bestimmter Sollwert oder ein bestimmter Grenzwert, durch einen Schaltparameter der Ansteuereinrichtung festgelegt. Ein konkreter Parameterwert des Schaltparameters ist dabei während eines Betriebes der Schaltungsanordnung veränderbar. Bezogen auf die Beispiele können also der Sollwert bzw. der Grenzwert im Betrieb verändert werden. Das Schaltverhalten der erfindungsgemäßen Schaltungsanordnung lässt sich somit durch Verändern eines bestimmten Parameterwertes während des Betriebes gezielt ändern und an einen aktuellen Betriebszustand des Halbleiter-Leistungsschalters anpassen. Das Schaltverhalten muss also nicht mehr durchgehend derart angepasst sein, dass eine Induktion einer unzulässig hohen Spannung durch Induktivitäten stets für eine Worst-Case-Bedingung verhindert wird. Dahinter steht die Erkenntnis, dass die Schaltdauer nur dann verlängert werden muss, wenn auch tatsächlich eine hohe Induktionsspannung zu erwarten ist. In allen übrigen Fällen kann der zu schaltende Strom schnell unterbrochen werden. Dies vermeidet die Schaltverluste, wie sie bei einem verzögerten Übergang beispielsweise mit einem rampenförmigen Verlauf der Steuerspannung entstehen.

Eine weitere Erkenntnis ist, dass die maximal zulässige Spannung über dem Halbleiter-Leistungsschalter von dessen Temperatur abhängt. Ein bestimmter Typ eines Halbleiter-Leistungsschalters kann z.B. besonders spannungsresistent sein, wenn er verhältnismäßig warm ist. In diesem Fall ist dann eine kürzere Schaltdauer durch Vorgabe entsprechender Parameterwerte möglich.

Natürlich gilt das für das Unterbrechen des Stromes Gesagte auch für ein Anschalten desselben.

Das erfindungsgemäße Verfahren sieht vor, einen Halbleiter-Leistungsschalter mittels einer Signalgebereinrichtung, mit der sich ein Schaltsignal erzeugen lässt, sowie mittels einer Ansteuereinrichtung zu steuern, wobei letztere eine Steuerspannung für den Halbleiter-Leistungsschalter in Abhängigkeit von dem Schaltsignal erzeugt. Zum Schalten des Halbleiter-Leistungsschalters wird das Schaltsignal mittels der Signalgebereinrichtung erzeugt und an die Ansteuereinrichtung übertragen. Diese empfängt das Schaltsignal und erzeugt eine Steuerspannung an einem Steuereingang des Halbleiter-Leistungsschalters in Abhängigkeit von dem Schaltsignal. Zunächst wird aber ein Betriebszustand des Halbleiter-Leistungsschalters ermittelt und in Abhängigkeit von dem ermittelten Betriebszustand wenigstens ein Parameterwert eines Schaltparameters der Ansteuereinrichtung festgelegt. Durch den Parameterwert des Schaltparameters ist dann während eines Schaltvorganges des Halbleiter-Leistungsschalters ein Kriterium für eine Betriebsgröße des Halbleiter-Leistungsschalters festgelegt. Während des Schaltvorganges wird dann eine Steuerspannung mit einem zeitlichen Verlauf des Spannungswerts in der Weise erzeugt, dass die Betriebsgröße das durch den Parameterwert vorgegebene Kriterium erfüllt.

Die erfindungsgemäße Schaltungseinrichtung weist in einer vorteilhaften Ausführungsform eine Messeinrichtung zum Erfassen wenigstens einer Betriebsgröße auf. Diese gemessene Betriebsgröße muss nicht zwingend dieselbe sein, die nachher beim Schalten berücksichtigt wird. So kann etwa eine Temperatur eines Transistors des Halbleiter-Leistungsschalters oder eine Temperatur einer zu dem Transistor anti-parallel geschalteten Diode des Halbleiter-Leistungsschalters gemessen werden. Bei Halbleiter-Bauelementen sind die Sperrfähigkeit und das Schaltverhalten oftmals von der Temperatur abhängig. Mit bekannter Temperatur kann somit ein Grenzwert für die über dem Halbleiter-Leistungsschalter abfallende Spannung vorgegeben werden. Durch Messen der Betriebsgröße ist der aktuelle Betriebszustand des Halbleiter-Leistungsschalters dann bekannt, und es kann ein passender Wert für den Schaltparameter festgelegt werden.

Bei einer anderen Weiterbildung der erfindungsgemäßen Schaltungsanordnung wird eine Stromstärke eines durch den Halbleiter-Leistungsschalter fließenden Stromes gemessen. Hier ergibt sich der Vorteil, dass aus dem Messwert ermittelt werden kann, ob überhaupt das Risiko besteht, dass bei einem schnellen Sperren (oder Öffnen) des Halbleiter-Leistungsschalters eine unzulässig hohe Spannung entsteht.

Es kann auch vorgesehen sein, dass eine über dem Halbleiter-Leistungsschalter abfallende Spannung, also z.B. eine Kollektor-Emitter-Spannung eines Transistors, mittels der Messeinrichtung gemessen wird. Anhand dieser Betriebsgröße lässt sich dann z. B. feststellen, wie nahe sich der Halbleiter-Leistungsschalter bereits an einem höchstens zulässigen Sperrspannungswert befindet und wie groß infolgedessen eine induzierte Spannung höchstens sein darf. Entsprechend schnell (oder langsam) kann dann der Halbleiter-Leistungsschalter geschaltet werden.

Es kann auch vorgesehen sein, dass durch die Messeinrichtung ein zeitlicher Mittelwert zu einer der vorhergehenden Größen ermittelt wird. Hierdurch lässt sich ein störender Einfluss von kurzzeitigen Lastspitzen auf die Messung verringern.

Erfindungsgemäß ist vorgesehen, eine Betriebsgröße des Halbleiter-Leistungsschalters, insbesondere eine Temperatur desselben, auf der Grundlage eines numerischen Modells in Abhängigkeit von wenigstens einer anderen Betriebsgröße zu ermitteln. Dann muss kein zusätzlicher Sensor zum Messen der erstgenannten Betriebsgröße bereitgestellt sein.

In einer Ausführungsform der erfindungsgemäßen Schaltungsanordnung ist die Ansteuereinrichtung dazu ausgelegt, in Abhängigkeit von einem Betriebszustand des Halbleiter-Leistungsschalters den Parameterwert selbständig festzulegen, insbesondere auf der Grundlage einer Kennlinie. Dadurch ergibt sich der Vorteil, dass ein Gerät, in welchem die erfindungsgemäße Schaltungsanordnung verwendet werden soll, nicht dahingehend angepasst werden muss, dass es einen Parameterwert für die Ansteuereinrichtung ermitteln kann. Die Ansteuereinrichtung ist dann selbst dazu in der Lage. Die Verwendung einer Kennlinie (oder mehrerer davon) hat dabei den Vorteil, dass bei der Schaltungsanordnung der Typ des Halbleiter-Leistungsschalters beim Ermitteln des Parameterwerts einfach dadurch berücksichtigt werden kann, dass eine passende Kennlinie in der Ansteuereinrichtung gespeichert wird.

In einer anderen Weiterbildung ist die Ansteuereinrichtung dazu ausgelegt, den Parameterwert für einen vorbestimmten Schaltparameter zusammen mit dem Schaltsignal über eine Steuerleitung zu empfangen. Dadurch ergibt sich der Vorteil, dass das Schaltverhalten im Voraus an eine zukünftige Folge von Schaltbefehlen angepasst werden kann.

Die beiden vorangehend beschriebenen Möglichkeiten der Ermittlung eines Parameterwerts können auch kombiniert werden. So kann für einen der Schaltparameter ein Parameterwert durch die Ansteuereinrichtung bestimmt und einer für einen anderen der Schaltparameter zusammen mit dem Schaltsignal von außerhalb durch die Ansteuereinrichtung empfangen werden.

Erfindungsgemäß ist die Ansteuereinrichtung dazu ausgelegt, über einen Schalteingang ein digitales Signal auf der Grundlage eines fehlertoleranten Übertragungsprotokolls zu empfangen und/oder über einen Messausgang ein digitales Signal auf der Grundlage eines fehlertoleranten Übertragungsprotokolls auszusenden. Hierdurch kann verhindert werden, dass eine Störstrahlung dazu führt, dass das Schaltverhalten der Schaltungsanordnung in unerwünschter Weise beeinflusst wird.

Die Erfindung wird im Folgenden anhand von Ausführungsbeispielen näher erläutert. Dazu zeigt:
- FIG 1: eine schematische Darstellung eines prinzipiellen Aufbaus eines Umrichters;
- FIG 2: eine schematische Darstellung einer Ansteuerschaltung und eines HalbleiterLeistungsschalters, die zusammen eine Ausführungsform der erfindungsgemäßen Schaltungsanordnung bilden;
- FIG 3: ein Diagramm, in welchem veranschaulicht ist, welchen Einfluss auf einen Abschaltvorgang Schaltparameter haben, die bei der Ansteuerschaltung von FIG 2 einstellbar sein können;
- FIG 4: ein Diagramm, in welchem veranschaulicht ist, welchen Einfluss auf einen Einschaltvorgang Schaltparameter haben, die bei der Ansteuerschaltung von FIG 2 einstellbar sein können;
- FIG 5: ein Diagramm, in welchem ein Zusammenhang zwischen einer Temperatur des HalbleiterLeistungsschalters von FIG 2 und dessen höchstens zulässiger Sperrspannung dargestellt ist;
- FIG 6 bis FIG 11: jeweils eine schematische Darstellung einer Ansteuerschaltung mit einem HalbleiterLeistungsschalter, die zusammen jeweils eine weitere Ausführungsform der erfindungsgemäßen Schaltungsanordnung bilden.

Die Beispiele stellen bevorzugte Ausführungsformen der Erfindung dar.

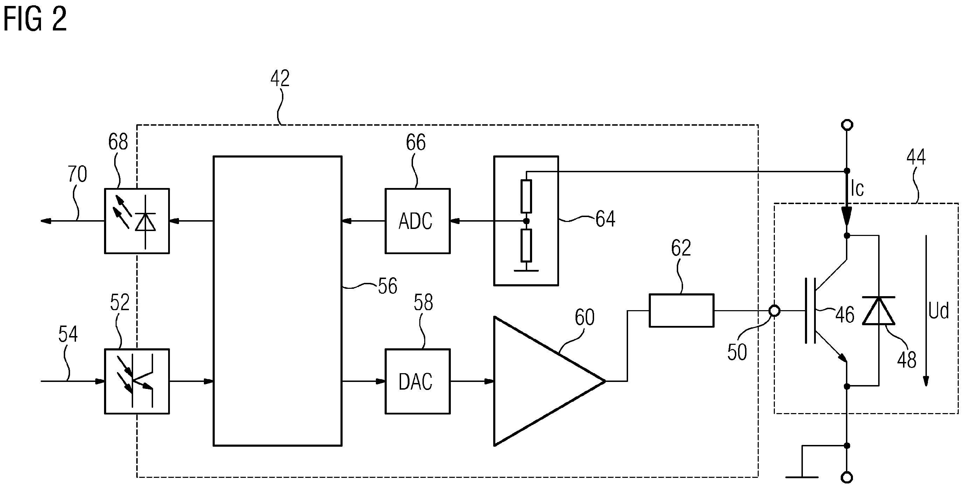

In FIG 2 ist eine Ansteuerschaltung 42 gezeigt, die in einem (in FIG 2 nicht näher dargestellten) steuerbaren Umrichter eines Frequenzumrichters eingebaut ist. Eine Bauweise des Umrichters kann beispielsweise derjenigen des Umrichters 10 entsprechen. Die Ansteuerschaltung 42 steuert einen Halbleiter-Leistungsschalter 44. Dieser weist einen Transistor 46 (hier einen IGBT) und eine zu diesem anti-parallel geschaltete Diode 48 auf. Anstelle des IGBT kann z.B. auch ein MOSFET vorgesehen sein. Zum Steuern des Halbleiter-Leistungsschalters 44 erzeugt die Ansteuerschaltung 42 eine Steuerspannung an einem Steuereingang 50 des Halbleiter-Leistungsschalters 44. Der Steuereingang 50 entspricht hier dem Gate des IGBT 46. Die Ansteuerschaltung 42 und der Halbleiter-Leistungsschalter 44 stellen zusammen eine Ausführungsform der erfindungsgemäßen Schaltungsanordnung dar. Mittels des Halbleiter-Leistungsschalters 44 wird ein Strom Ic gesteuert.

Die Steuerspannung wird in Abhängigkeit von einem Schaltsignal erzeugt, welches die Ansteuerschaltung 42 über einen Lichtempfänger oder Eingangs-Optokoppler 52 empfängt, über den die Ansteuerschaltung 42 mit einer Signalleitung 54 einer (nicht dargestellten) Umrichtersteuerung verbunden ist. Die Umrichtersteuerung ist eine Signalgebereinrichtung des Umrichters ähnlich der bereits beschriebenen Steuereinheit 34.

Das Schaltsignal wird von einer programmierbaren Steuereinrichtung 56 ausgewertet. Die Steuereinrichtung kann z.B. durch einen FPGA (field programmable gate array) oder einen ASIC (application-specific integrated circuit) bereitgestellt sein. Über das Schaltsignal gibt die Umrichtersteuerung vor, ob sich der Halbleiter-Leistungsschalter 44 in einem leitenden oder einem sperrenden Zustand befinden soll. Die Steuereinrichtung 56 erzeugt ein entsprechendes digitales Signal, zu welchem von einem Digital-Analog-Wandler 58 ein analoges Signal erzeugt wird. Das analoge Signal wird von einer Verstärkerschaltung 60 verstärkt und als Steuerspannung über einen Gate-Widerstand 62 zum Steuereingang 50 übertragen.

In der Steuereinrichtung 56 kann ein digitales Filter oder eine digitale Regelung vorgesehen sein, um aus dem Schaltsignal der Umsteuerschaltung ein zum Ansteuern des Halbleiter-Leistungsschalters 44 geeignetes digitales Signal zu erzeugen. Zudem ist es möglich, Schutzfunktionen z.B. für den Halbleiter-Leistungsschalter 44 vorzusehen. Die Steuereinrichtung 56 bildet eine digitale Schnittstelle zwischen der Umrichtersteuerung und dem Halbleiter-Leistungsschalter 44.

Die Ansteuerschaltung 42 weist eine Spannungsmesseinrichtung 64 auf, mit welcher die Kollektor-Emitter-Spannung Uce des Transistors 46 erfasst wird. Diese entspricht hier zugleich der Diodenspannung Ud. Über einen Analog-Digital-Wandler 66 wird der erfasste Spannungswert in einen digitalen Messwert umgewandelt, der von der Steuereinrichtung 56 ausgewertet wird. Die Diodenspannung Ud stellt eine Betriebsgröße des Halbleiter-Leistungsschalters 44 dar.

Bei der Ansteuerschaltung 42 können über einen Lichtsender oder Ausgangs-Optokoppler 68 und eine Signalleitung 70 Daten, wie z.B. digitale Messwerte oder Zustandsinformationen, zur Umrichtersteuerung übertragen werden.

Bei der Ansteuerschaltung 42 ist es erfindungsgemäß vorgesehen, dass zum Austauschen von Daten zwischen der Umrichtersteuerung und der Steuereinrichtung 56 ein fehlertolerantes Übertragungsprotokoll verwendet wird, so dass auch bei einer Verfälschung der Daten, beispielsweise durch eine Störstrahlung, die ursprünglich gesendeten Informationen (bis zu einem bestimmten Grad der Verfälschung) wieder aus den verfälschten Daten rekonstruiert werden können. Beispiele für ein solches Übertragungsprotokoll sind ein Barker-Code und ein zyklischer Code. Wenn durch das Schaltsignal der Steuerleitung 54 ein Wechsel des Schaltzustands des Halbleiter-Leistungsschalters 44, also von leitend auf sperrend oder umgekehrt, durch die Umrichtersteuerung vorgegeben wird, so wird von der Ansteuerschaltung 42 ein entsprechender Schaltvorgang durch Verändern der Steuerspannung am Steuereingang 50 bewirkt. Das Schaltverhalten der Ansteuerschaltung 42 ist dabei durch Schaltparameter der Steuereinrichtung 56 bestimmt, deren Werte während des Betriebs der Ansteuerschaltung 42 verändert werden können. Die Werte für die Schaltparameter sind bei der Ansteuerschaltung 42 zusammen mit dem Schaltsignal über die Steuerleitung 54 von der Umrichtersteuerung zur Steuereinrichtung 56 übertragbar.

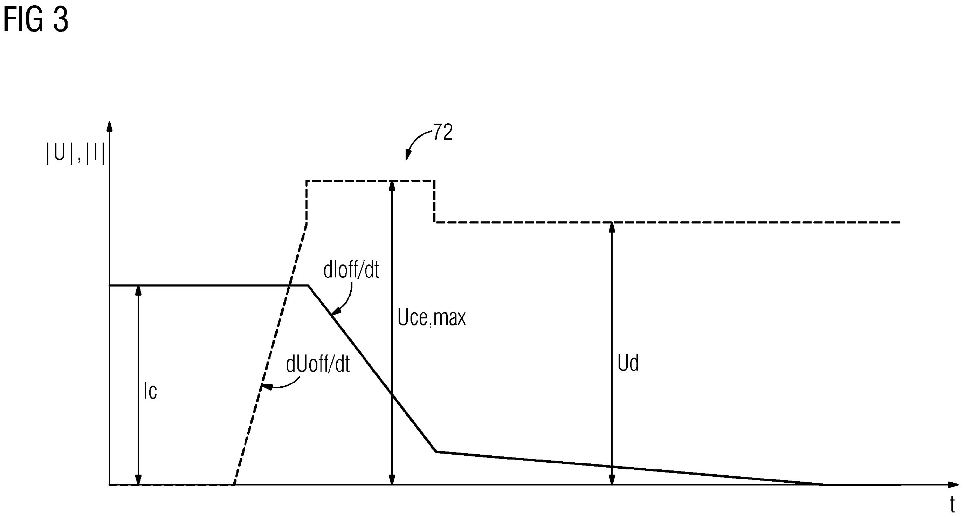

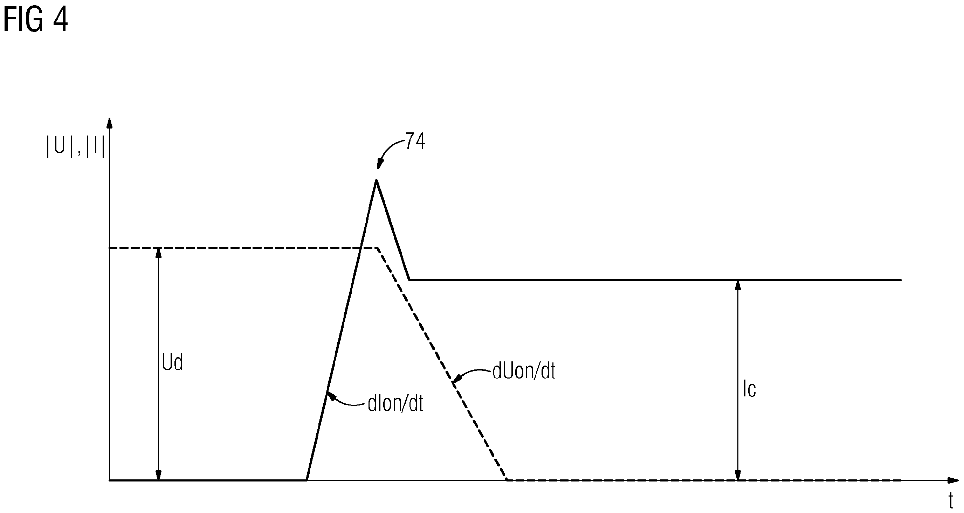

Anhand von FIG 3 und FIG 4 ist im Folgenden erläutert, welchen Einfluss das Einstellen von Schaltparametern auf einen bestimmten Wert auf einen Schaltvorgang hat.

In FIG 3 ist ein Verlauf der Stromstärke des Stromes Ic und der Spannung Ud während eines Abschaltvorganges gezeigt. Zum Unterbrechen des Stromes Ic wird seine Stromstärke graduell verringert, so dass der zeitliche Verlauf der Stromstärke während des Schaltvorganges eine endliche Steigung aufweist. Eine Steigung dIoff/dt (Ableitung von Ic nach der Zeit während des Abschaltens) stellt dabei einen Schaltparameter dar. Diese Steigung entspricht der Schaltgeschwindigkeit, mit welcher der Schaltvorgang durchgeführt wird.

Durch Festlegen eines bestimmten Parameterwerts des Schaltparameters für die Steigung dIoff/dt bei der Steuereinrichtung 56 wird in dem gezeigten Beispiel vorgegeben, dass während des Abschaltens die Stromstärke des Stromes Ic die Bedingung erfüllt, dass die Steigung dIoff/dt vom Betrage her nicht größer als der eingestellte Parameterwert werden darf. Diese Bedingung stellt somit ein Kriterium dar, das während des Schaltvorgangs erfüllt sein muss. Bei der Steuereinrichtung 56 kann zum Einhalten der Bedingung ein entsprechender Steueralgorithmus oder ein Regelalgorithmus mit einem geschlossenen Regelkreis bereitgestellt sein.

Einen zweiten Schaltparameter stellt ein Spannungshöchstwert Uce,max der Kollektor-Emitter-Spannung Uce dar, der nicht überschritten werden darf. Als ein dritter Schaltparameter kann die Steigung dUoff/dt der Diodenspannung Ud vorgebbar sein. Der Verlauf der Spannung Ud weist bei dem Abschaltvorgang eine Überhöhung 72 auf, die durch eine Spannung verursacht wird, welche durch eine (in FIG 2 nicht dargestellte) Induktivität beim Abschalten des Stromes Ic erzeugt wird. Der Höchstwert der Überhöhung 72, d.h. der Spannungshöchstwert Uce,max, kann durch Einstellen von Werten der Schaltparameter für Uce,max und/oder dUoff/dt beeinflusst werden.

In FIG 4 sind entsprechende Angaben wie in FIG 3 zu einem Anschaltvorgang gemacht. Gezeigt sind wieder ein zeitlicher Verlauf der Diodenspannung Ud und der Stromstärke des Stromes Ic. Hierzu kann vorgesehen sein, über Schaltparameter eine Steigung dIon/dt der Stromstärke des Stromes Ic und/oder eine Steigung dUon/dt bei der Steuereinrichtung 56 vorgeben zu können. Der Verlauf des Diodenstromes Ic weist eine Spitze 74 auf, die durch das Rückstromverhalten der abkommutierten Freilaufdiode verursacht wird. Ein Höchstwert der Stromspitze 74 kann durch Einstellen von Werten der Schaltparameter beeinflusst werden.

Der Spannungshöchstwert Uce,max und die Steigungen dIon/dt, dUon/dt, dIoff/dt und dUoff/dt stellen Betriebgrößen des Halbleiter-Leistungsschalters 44 dar. Im Folgenden werden für die Schaltparameter der Steuereinrichtung 56 dieselben Bezeichnungen verwendet wie für die Betriebsgrößen, welche sie beeinflussen. Somit können also Schaltparameter Uce,max, dIon/dt, dUon/dt, dIoff/dt und/oder dUoff/dt vorgesehen sein. Bei der Steuereinrichtung 56 müssen aber nicht für alle der beschriebenen Betriebsgrößen Schaltparameter vorgesehen sein.

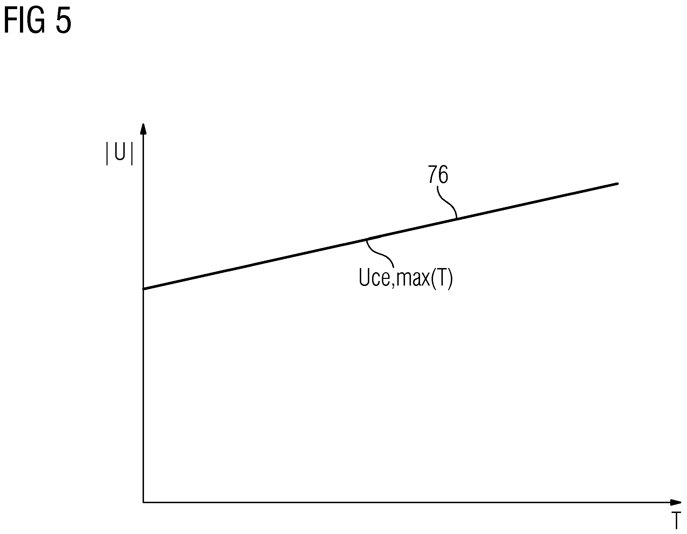

In FIG 5 ist eine Kennlinie 76 gezeigt, durch welche eine Abhängigkeit einer höchstens zulässigen Sperrspannung Uce,max(T) von einer Temperatur T des Transistors 46 beschrieben ist. Die Sperrfähigkeit des Transistors 46 nimmt gemäß der Kennlinie 76 mit der Temperatur T ab. Die Kennlinie 76 kann z.B. als messtechnisch ermittelte Wertetabelle oder auch als mathematische Funktion bereitgestellt sein.

Durch die Einführung der digitalen Steuereinrichtung 56 ist es möglich, das Schalten des Transistors 44 von dessen Temperatur T sowie seinen Schalteigenschaften online, also während des Betriebs, zu beeinflussen. Eine Auslegung der IGBT-Ansteuerung auf besonders ungünstigste Bedingung (worst case) kann somit entfallen. Eine Worst-Case-Bedingung kann sich beispielsweise ergeben, wenn der Strom Ic bei einer sehr niedrigen Temperatur geschaltet werden muss. Der Halbleiter-Leistungsschalter 44 weist bei niedriger Temperatur neben einer geringeren zulässigen Maximalspannung (siehe FIG 5) noch ein verändertes Schaltverhalten auf, was in Verbindung mit Streuinduktivitäten zu einer erhöhten Spannungsbelastung führen kann. Durch Anpassen der Schaltparameter an den tatsächlichen Betriebszustand des Halbleiter-Leistungsschalters 44 können die Schaltverluste verringert und die Ausnutzung des Halbleiter-Leistungsschalters 44 (z.B. seine Lebensdauer) erhöht werden.

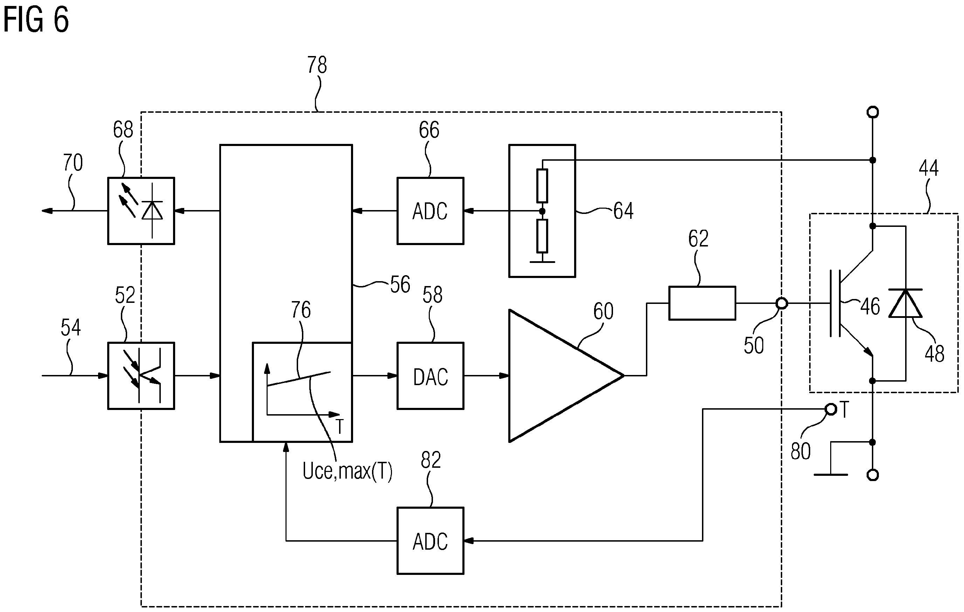

In FIG 6 bis FIG 11 sind weitere Schaltungsanordnungen mit jeweils einer Ansteuerschaltung und einem Halbleiter-Leistungsschalter gezeigt. In den Figuren sind Elemente, deren Funktionsweise Elementen von FIG 2 entsprechen, mit denselben Bezugszeichen versehen wie in FIG 2. Diese Elemente werden im Folgenden nicht noch einmal erläutert.

In FIG 6 ist eine Ansteuerschaltung 78 gezeigt, die mit einem Temperatursensor 80 verbunden ist. Der Temperatursensor 80 misst eine Temperatur T eines Halbleiter-Leistungsschalters 44. Es kann sich in dem gezeigten Beispiel um die Temperatur eines Transistors 46 oder einer Diode 48 des Halbleiter-Leistungsschalters 44 handeln. Der Temperatursensor 80 kann z.B. auf einem Kühlkörper des Halbeiter-Leistungsschalters 44 oder innerhalb des Halbeiter-Leistungsschalters 44 angeordnet sein. Ein Messwert des Temperatursensors 80 wird durch einen Analog-Digital-Wandler 82 in einen digitalen Messwert umgewandelt, der von einer Steuereinrichtung 56 beim Erzeugen einer Steuerspannung zum Steuern des Halbleiter-Leistungsschalters 44 als Betriebsgröße desselben berücksichtigt wird.

In der Steuereinrichtung 56 ist eine Kennlinie 76 gespeichert, wie sie in FIG 5 dargestellt ist. Anhand der Kennlinie 76 wird in Abhängigkeit von der Temperatur T ein Wert für die höchstens zulässige Sperrspannung Uce,max(T) ermittelt. Der ermittelte Wert wird als Parameterwert für einen Schaltparameter Uce,max der Steuereinrichtung 56 eingestellt.

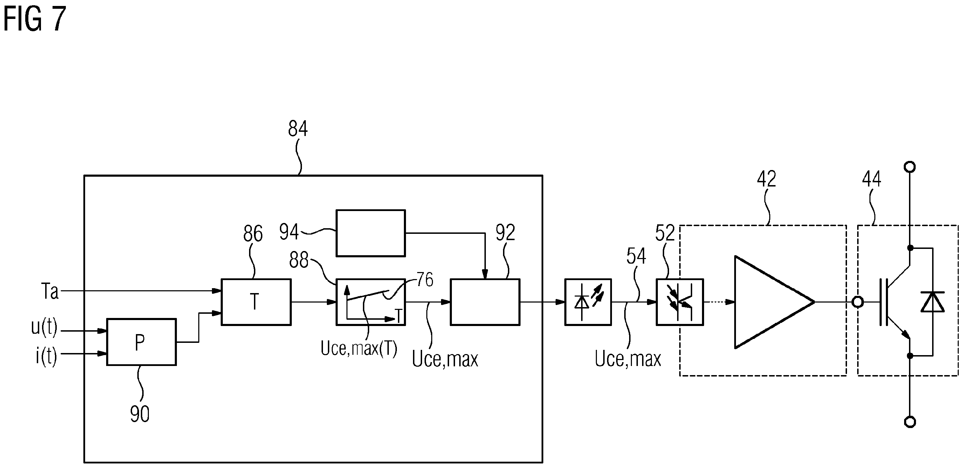

In FIG 7 ist eine Umrichtersteuerung 84 eines Umrichters gezeigt, die über eine Steuerleitung 54 ein Schaltsignal an eine Ansteuerschaltung sendet, die der bereits in FIG 2 gezeigten Ansteuerschaltung 42 entspricht. Die Umrichtersteuerung 84 stellt eine Signalgebereinrichtung dar. Sie sendet das Schaltsignal zusammen mit einem Parameterwert für den Schaltparameter Uce,max. Der Parameterwert wird auf der Grundlage eines numerischen Modells 86 ermittelt. Mittels des Modells 86 kann eine momentane Temperatur T eines Halbleiter-Leistungsschalters 44 berechnet werden. Anhand der berechneten Temperatur T wird durch die Umrichtersteuerung 84 mittels einer Kennlinie 76 (siehe FIG 5) der Parameterwert bestimmt. Die Kennlinie 76 ist in einem Kennlinienspeicher 88 gespeichert.

Das numerische Modell 86 benötigt als Eingangsparameter eine Anfangstemperatur Ta des Halbleiter-Leistungsschalters 44, die dieser zum einem Betriebsbeginn des Umrichters aufgewiesen hat. Ein weiterer Eingangsparameter ist eine Leistung P, welche seit Betriebsbeginn in dem Halbleiter-Leistungsschalter 44 umgesetzt wurde. Die Leistung P wird in einer Berechnungseinheit 90 aus Zeitverläufen einer Betriebsspannung u(t) und eines Betriebsstromes i(t) ermittelt, die von dem Umrichter mittels des Halbleiter-Leistungsschalters 44 seit Betriebsbeginn an einem (nicht dargestellten) Anschluss bereitgestellt wurden.

Eine Kommunikationseinheit 92 überträgt den ermittelten Parameterwert zusammen mit einem von einer das eigentliche Schaltsignal erzeugenden Taktgebereinrichtung 94 über die Steuerleitung 54. Über weitere, in FIG 7 nicht gezeigte Steuerleitungen werden Parameterwerte auch an weitere (nicht dargestellte) Ansteuerschaltungen des Umrichters übertragen. Die Werte für die Schaltparameter werden erfindungsgemäß unter Verwendung eines fehlertoleranten Übertragungsprotokolls an die einzelnen Ansteuerschaltungen des Umrichters übertragen und können dort in programmierbaren Steuereinrichtungen als Parameterwerte in die programmierbaren Steuereinrichtungen übernommen werden.

Anstelle des Temperaturmodells kann auch eine Messung der Temperatur innerhalb des Umrichters erfolgen.

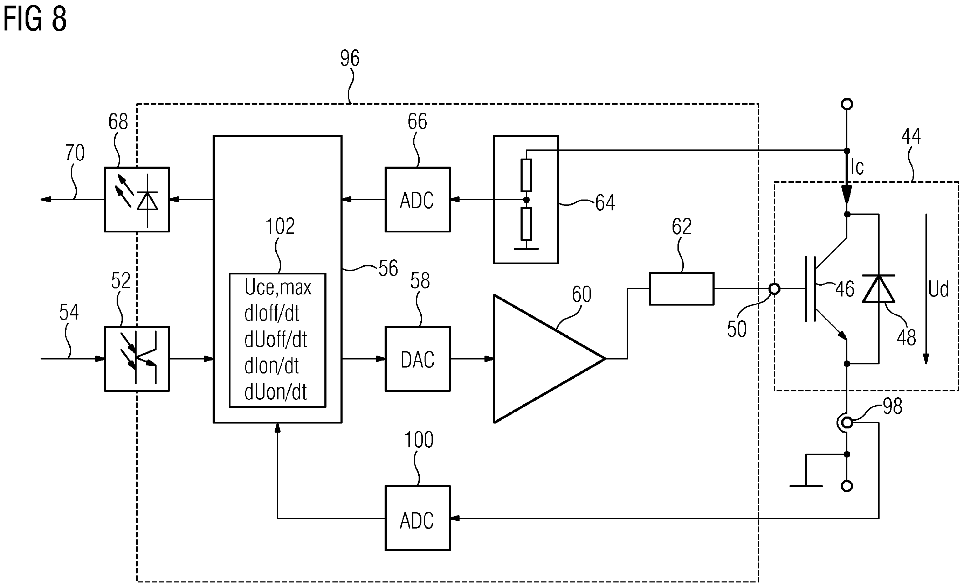

In FIG 8 ist eine Ansteuerschaltung 96 gezeigt, an die ein Stromwandler 98 angeschlossen ist. Der Stromwandler 98 misst eine Stromstärke eines zu schaltenden Stromes Ic. Ein Messwert des Stromwandlers 98 wird hier durch einen Analog-Digital-Wandler 100 der Ansteuerschaltung 96 in einen digitalen Messwert umgewandelt, der von einer Steuereinrichtung 56 beim Erzeugen einer Steuerspannung zum Steuern eines Halbleiter-Leistungsschalters 44 als Betriebsgröße desselben berücksichtigt wird. Bei dem Halbleiter-Leistungsschalter 44 kommt es bei dem darin eingebauten Typ eines Transistors 46 und dem Typ einer eingebauten Diode 48 unter bestimmmten Betriebsbedingungen zu Aufsteilungen, wie einer Überhöhung 72 (FIG 3) beim Sperren oder einer Spitze 74 (FIG 4) beim Schließen des Halbleiter-Leistungsschalters 44. Grund dafür kann z.B. ein Strom- oder Spannungsabriss sein, d.h. eine abrupte Veränderung der Beträge dieser Größen. Dieses Verhalten ist aber auf sehr wenige Betriebspunkte beschränkt. Anhand einer Messung des Stromes Ic mittels des Stromwandlers 98 und einer Messung einer Diodenspannung Ud mittels einer Spannungsmesseinrichtung 64 kann schon vor einem eigentlichen Schaltvorgang im Voraus ermittelt werden, ob ein solcher Betriebspunkt vorliegt. Mit anderen Worten können durch Messen der Betriebsgrößen Ic und Ud der Betriebszustand des Halbleiter-Leistungsschalters 44 ermittelt und Schaltparameter der Steuereinrichtung 56 im Voraus entsprechend festgelegt werden. In dem in FIG 8 gezeigten Beispiel können anhand der Messwerte für die Diodenspannung Ud und der Stromstärke des zu schaltenden Stromes Ic Parameterwerte für Schaltparameter Uce,max, dIoff/dt, dUoff/dt, dIon/dt und dUon/dt ermittelt werden. Die für den jeweiligen Betriebszustand günstigsten Parameterwerte sind hier in einer Tabelle 102 innerhalb der Steuereinrichtung 56 hinterlegt.

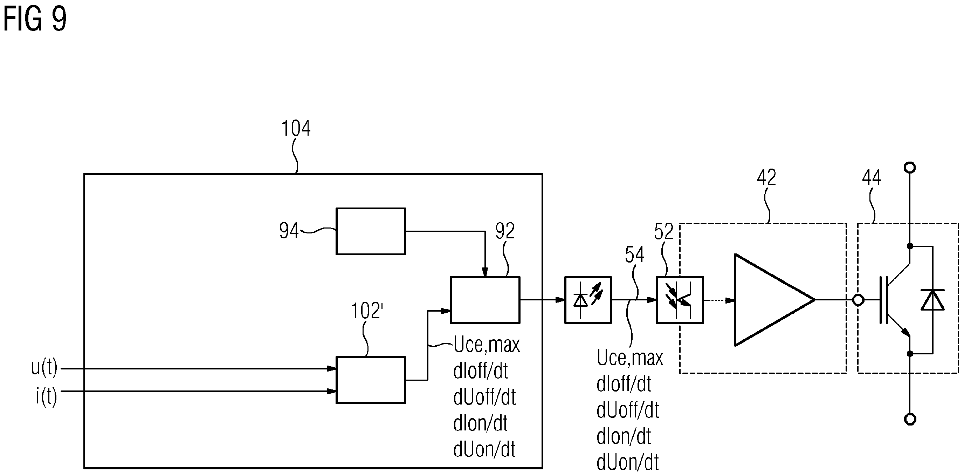

In FIG 9 ist eine Umrichtersteuerung 104 eines (nicht weiter dargestellten) Umrichters gezeigt, die eine Tabelle 102' aufweist, mittels welcher ähnlich wie mit der Tabelle 102 Parameterwerte für Schaltparameter einer Ansteuerschaltung 42 ermittelt werden können. Die ermittelten Parameterwerte werden von einer Kommunikationseinheit 92 zusammen mit einem Schaltsignal einer Taktgebereinrichtung 94 in der im Zusammenhang mit FIG 7 beschriebenen Weise an die Ansteuerschaltung 42 (und weitere, nicht dargestellte Ansteuerschaltungen) übertragen. Mittels der Tabelle 102' kann die Ermittlung der Parameterwerte auf der Grundlage eines aktuellen Betriebszustands erfolgen, der anhand von Messungen von Zeitverläufen einer Betriebsspannung u(t) und eines Betriebsstromes i(t) ermittelt wird.

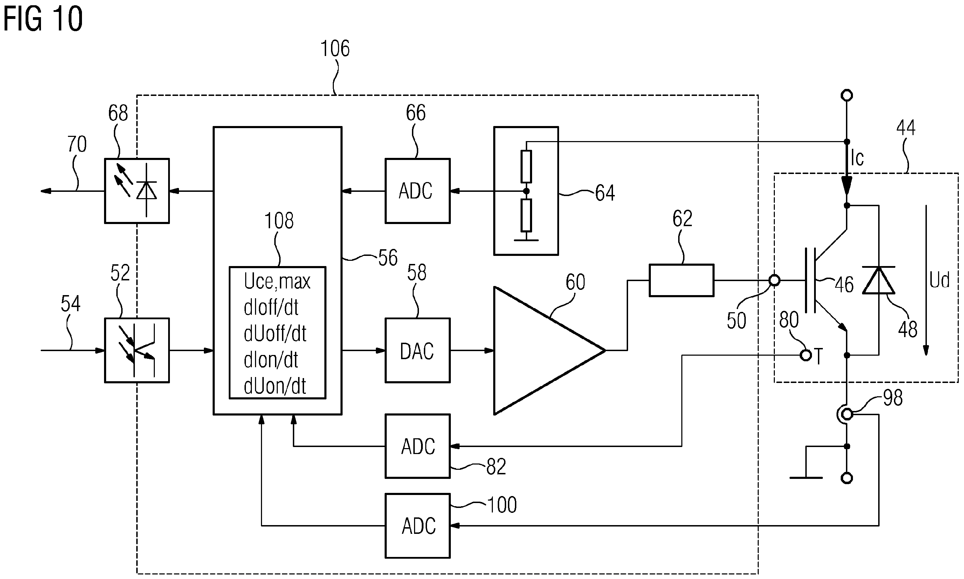

In FIG 10 ist eine Ansteuerschaltung 106 gezeigt, bei welcher Schaltparameter Uce,max, dIoff/dt, dUoff/dt, dIon/dt, dUon/dt einer Steuereinrichtung 56 in Abhängigkeit von drei Betriebsgrößen eines Halbleiter-Leistungsschalters 44 ermittelt werden, nämlich einem Strom Ic, einer Diodenspannung Ud und einer Temperatur T eines Halbleiter-Leistungsschalters 44. Die Temperatur T des Halbleiter-Leistungsschalters 44 wird erfasst und die zulässige temperaturabhängige Schaltgeschwindigkeit dIoff/dt, dIon/dt in Abhängigkeit vom Strom Ic und der Spannung Ud aus einer zuvor messtechnisch ermittelten Tabelle 108 bestimmt und als Parameterwert der Schaltparameter dIoff/dt, dIon/dt festgelegt. Auch die Werte der übrigen Schaltparameter Uce,max, dUoff/dt und dUon/dt werden anhand der Tabelle und in Abhängigkeit vom aktuellen Betriebszustand festgelegt.

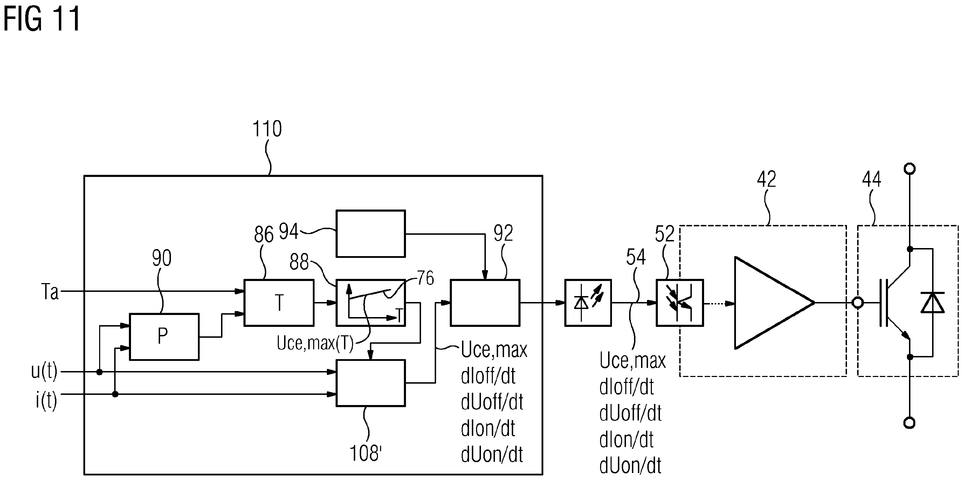

In FIG 11 ist eine Umrichtersteuerung 110 gezeigt, welche Schaltparameter Uce,max, dIoff/dt, dUoff/dt, dIon/dt, dUon/dt in einer Weise ermittelt, wie es auch durch die Steuereinrichtung 56 der Ansteuerschaltung 106 ermöglicht ist. Anstelle einer Temperaturmessung ist hier erfindungsgemäß die Verwendung eines numerischen Modells 86 vorgesehen. Auf der Grundlage des ermittelten Betriebszustands eines Halbleiter-Leistungsschalters 44 werden anhand einer Tabelle 108' die Parameterwerte für die Schaltparameter Uce,max, dIoff/dt, dUoff/dt, dIon/dt, dUon/dt ermittelt und an eine Ansteuerschaltung 42 übermittelt.

Durch die Beispiele ist gezeigt, wie mittels einer digital programmierbaren Ansteuerschaltung die Möglichkeit geschaffen ist, während eines Betriebs eines Umrichters Schaltparameter neu zu konfigurieren oder zu verändern. Es kann eine temperaturabhängige Online-Beeinflussung der zulässigen Maximalspannung im Schaltbetrieb zur Reduzierung der Schaltverluste ermöglicht sein. Genauso kann eine strom- und spannungsabhängige Online-Beeinflussung der Einschalt- und Ausschaltparameter ermöglich sein. Die Übertragung von Parameterwerten zur Beeinflussung des Schaltverhaltens kann zusammen mit einem Schaltsignal codiert erfolgen. Dabei erfolgt die Übertragung von Parameterwerten erfindungsgemäß mit Hilfe eines fehlertoleranten Übertragungsprotokolls.

Es kann somit erreicht werden, dass Schaltverluste eines Halbleiter-Leistungsschalters 44 über einen großen Bereich von möglichen Betriebstemperaturen des Halbleiter-Leistungsschalters 44 konstant gehalten werden. Da die Schaltgeschwindigkeit nun nicht mehr auf den tiefsten Temperaturwert (worst case) zur Begrenzung der auftretenden Überspannungen angepasst sein muss (siehe FIG 5), kann so bei höheren Temperaturen eine deutlich höhere Schaltgeschwindigkeit erreicht und damit die Verlustleistung verringert werden.

## Patentansprüche

1. Schaltungsanordnung zum Schalten eines Stromes (Ic) in Anhängigkeit von einem vorgebbaren Schaltsignal, umfassend:
- einen Halbleiter-Leistungsschalter (44) zum Schalten des Stromes (Ic) und
- eine Ansteuereinrichtung (42,78,96,106), welche dazu ausgelegt ist, das Schaltsignal zu empfangen und in Abhängigkeit von dem empfangenen Schaltsignal an einem Steuereingang (50) des Halbleiter-Leistungsschalters (44) eine Steuerspannung mit einem zeitlichen Verlauf zu erzeugen, durch welchen bewirkt ist, dass während eines Schaltvorgangs wenigstens eine vorbestimmte Betriebsgröße (Uce,max, dIoff/dt, dUoff/dt, dIon/dt, dUon/dt) des Halbleiter-Leistungsschalters (44) ein vorbestimmtes Kriterium erfüllt, wobei das Kriterium durch einen Schaltparameter (Uce,max, dIoff/dt, dUoff/dt, dIon/dt, dUon/dt) der Ansteuereinrichtung (42,78,96,106) vorgegeben ist und ein Parameterwert des Schaltparameters (Uce,max, dIoff/dt, dUoff/dt, dIon/dt, dUon/dt) während eines Betriebes der Schaltungsanordnung veränderbar ist
**dadurch gekennzeichnet,**
**dass** die Ansteuereinrichtung (42,78,96,106) dazu ausgelegt ist, über einen Schalteingang (52) ein digitales Signal auf der Grundlage eines fehlertoleranten Übertragungsprotokolls zu empfangen und/oder über einen Messausgang (68) ein digitales Signal auf der Grundlage eines fehlertoleranten Übertragungsprotokolls auszusenden, wobei eine Betriebsgröße des Halbleiter-Leistungsschalters (44), insbesondere eine Temperatur (T) desselben, auf der Grundlage eines numerischen Modells (86) in Abhängigkeit von wenigstens einer anderen Betriebsgröße (Ta, i(t), u(t)) ermittelt wird.

2. Schaltungsanordnung nach Anspruch 1, **dadurch gekennzeichnet , dass** zu wenigstens einer der folgenden Betriebsgrößen durch Festlegen eines Parameterwerts ein Kriterium vorgebbar ist:
- einer über einem Transistor und/oder einer Diode des Halbleiter-Leistungsschalters (44) abfallenden Spannung (Uce,max),
- einer Steigung (dUoff/dt, dUon/dt) eines zeitlichen Verlaufs dieser Spannung,
- einer Steigung (dIoff/dt, dIon/dt) eines zeitlichen Verlaufs des zu schaltenden Stromes (Ic) und/oder
- einem zeitlichen Mittelwert zu einer der vorhergehenden Größen.

3. Schaltungsanordnung nach Anspruch 1 oder 2, **dadurch gekennzeichnet , dass** durch den Parameterwert als Kriterium ein Grenzwert oder ein Sollwert für die Betriebsgröße (Uce,max, dIoff/dt, dUoff/dt, dIon/dt, dUon/dt) vorgebbar ist.

4. Schaltungsanordnung nach einem der vorhergehenden Ansprüche, **gekennzeichnet durch** eine Messeinrichtung (64,66,80,82,98,100) zum Erfassen wenigstens einer Betriebsgröße (Ic, T, Ud), **durch** welche ein Betriebszustand des Halbleiter-Leistungsschalters (44) beschrieben ist, insbesondere
- einer Temperatur (T) eines Transistors (46) des Halbleiter-Leistungsschalters (44),
- einer Temperatur einer zu dem Transistor (46) anti-parallel geschalteten Diode (48) des Halbleiter-Leistungsschalters (44),
- einer Stromstärke eines **durch** den Halbleiter-Leistungsschalter (44) fließenden Stromes (Ic),
- einer über dem Halbleiter-Leistungsschalter (44) abfallenden Spannung (Ud) und/oder
- einem zeitlichen Mittelwert zu einer der vorhergehenden Größen.

5. Schaltungsanordnung nach einem der vorhergehenden Ansprüche, **dadurch gekennzeichnet , dass** die Ansteuereinrichtung (78,96,106) dazu ausgelegt ist, in Abhängigkeit von einem Betriebszustand des Halbleiter-Leistungsschalters (44) den Parameterwert selbständig festzulegen, insbesondere auf der Grundlage einer Kennlinie (76).

6. Schaltungsanordnung nach einem der vorhergehenden Ansprüche, **dadurch gekennzeichnet , dass** die Ansteuereinrichtung (42) dazu ausgelegt ist, den Parameterwert für einen vorbestimmten Schaltparameter (Uce,max, dIoff/dt, dUoff/dt, dIon/dt, dUon/dt) zusammen mit dem Schaltsignal über eine Steuerleitung (54) zu empfangen.

7. Verfahren zum Steuern eines Halbleiter-Leistungsschalters (44) mittels einer Signalgebereinrichtung (84,104) zum Erzeugen eines Schaltsignals und mittels einer Ansteuereinrichtung (42,78,96,106) zum Erzeugen einer Steuerspannung für den Halbleiter-Leistungsschalter (44), umfassend die Schritte:
- Ermitteln eines Betriebszustands (Ic, T, Ud) des Halbleiter-Leistungsschalters (44) und Festlegen wenigstens eines Parameterwerts eines Schaltparameters (Uce,max, dIoff/dt, dUoff/dt, dIon/dt, dUon/dt) der Ansteuereinrichtung (42, 78,96,106), durch welchen während eines Schaltvorganges des Halbleiter-Leistungsschalters (44) ein Kriterium für wenigstens eine Betriebsgröße (Uce,max, dIoff/dt, dUoff/dt, dIon/dt, dUon/dt) des Halbleiter-Leistungsschalters (44) festgelegt ist;
- Erzeugen des Schaltsignals mittels der Signalgebereinrichtung (84,104) und Übertragen des Schaltsignals an die Ansteuereinrichtung (42,78,96,106);
- Empfangen des Schaltsignals durch die Ansteuereinrichtung (42,78,96,106) und Erzeugen einer Steuerspannung an einem Steuereingang (50) des Halbleiter-Leistungsschalters (44) in Abhängigkeit von dem Schaltsignal, wobei ein zeitlicher Verlauf eines Spannungswerts der Steuerspannung derart festgelegt wird, dass während eines Schaltvorgangs die Betriebsgröße (Uce,max, dIoff/dt, dUoff/dt, dIon/dt, dUon/dt) das durch den Parameterwert vorgegebene Kriterium erfüllt
**dadurch gekennzeichnet,**
**dass** die Ansteuereinrichtung (42,78,96,106) dazu ausgelegt ist, über einen Schalteingang (52) ein digitales Signal auf der Grundlage eines fehlertoleranten Übertragungsprotokolls zu empfangen und/oder über einen Messausgang (68) ein digitales Signal auf der Grundlage eines fehlertoleranten Übertragungsprotokolls auszusenden, wobei eine Betriebsgröße des Halbleiter-Leistungsschalters (44), insbesondere eine Temperatur (T) desselben, auf der Grundlage eines numerischen Modells (86) in Abhängigkeit von wenigstens einer anderen Betriebsgröße (Ta, i(t), u(t)) ermittelt wird.

8. Verfahren nach Anspruch 7, bei welchem zumindest eine der folgenden Betriebsgrößen des Halbleiter-Leistungsschalters (44) zum Ermitteln des Betriebszustands gemessen wird:
- eine Temperatur (T) eines Transistors (46) des Halbleiter-Leistungsschalters (44),
- eine Temperatur einer zu dem Transistor (46) anit-parallel geschalteten Diode (48) des Halbleiter-Leistungsschalters (44),
- eine Stromstärke eines durch den Halbleiter-Leistungsschalter (44) fließenden Stromes (Ic),
- eine über dem Halbleiter-Leistungsschalter (44) abfallende Spannung (Ud),
- ein zeitlicher Mittelwert zu einer der vorhergehenden Größen.

9. Verfahren nach Anspruch 8, bei welchem durch das Festlegen des Parameterwerts eines Schaltparameters (Uce,max, dIoff/dt, dUoff/dt, dIon/dt, dUon/dt) ein Sollwert oder ein Grenzwert für eine der folgenden Betriebsgrößen für einen Schaltvorgang vorgegeben wird:
- eine über einem Transistor (46) und/oder einer Diode (48) des Halbleiter-Leistungsschalters (44) abfallende Spannung (Ud),
- eine Steigung (dUoff/dt, dUon/dt) eines zeitlichen Verlaufs dieser Spannung (Ud),
- eine Steigung (dIoff/dt, dIon/dt) eines zeitlichen Verlaufs des zu schaltenden Stromes (Ic) oder
- ein zeitlicher Mittelwert zu einer der vorhergehenden Größen.

## Claims

1. Circuit arrangement for switching a current (Ic) as a function of a switching signal which can be predefined, comprising:
- a semiconductor circuit breaker (44) for switching the current (Ic) and
- an actuation device (42, 78, 96, 106) which is so designed as to receive the switching signal and to generate a control voltage having a temporal profile at a control input (50) of the semiconductor circuit breaker (44) as a function of the received switching signal, as a result of which during a switching action at least one predetermined operating variable (Uce,max, dIoff/dt, dUoff/dt, dIon/dt, dUon/dt) of the semiconductor circuit breaker (44) satisfies a predetermined criterion, wherein said criterion is predefined by a switching parameter (Uce,max, dIoff/dt, dUoff/dt, dIon/dt, dUon/dt) of the actuation device (42, 78, 96, 106) and a parameter value of the switching parameter (Uce,max, dIoff/dt, dUoff/dt, dIon/dt, dUon/dt) can be varied during operation of the circuit arrangement,
**characterised in that**
the actuation device (42, 78, 96, 106) is so designed as to receive a digital signal via a switching input (52) using a fault-tolerant transmission protocol and/or to transmit a digital signal via a measuring output (68) using a fault-tolerant transmission protocol, wherein an operating variable of the semiconductor circuit breaker (44), in particular a temperature (T) thereof, is determined on the basis of a numeric model (86) as a function of at least one other operating variable (Ta, i(t), u(t)).

2. Circuit arrangement according to claim 1,
**characterised in that** by means of establishing a parameter value, a criterion can be predefined for at least one of the following operating variables:
- a voltage (Uce,max) dropping over a transistor and/or a diode of the semiconductor circuit breaker (44),
- a gradient (dUoff/dt, dUon/dt) of a temporal profile of this voltage,
- a gradient (dIoff/dt, dIon/dt) of a temporal profile of the current (Ic) to be switched and/or
- an average value over time for one of the preceding variables.

3. Circuit arrangement according to claim 1 or 2,
**characterised in that** a limit value or a desired value for the operating variable (Uce,max, dIoff/dt, dUoff/dt, dIon/dt, dUon/dt) can be predefined as a criterion by the parameter value.

4. Circuit arrangement according to one of the preceding claims, **characterised by** a measuring device (64, 66, 80, 82, 98, 100) for capturing at least one operating variable (Ic, T, Ud), by means of which an operating state of the semiconductor circuit breaker (44) is described, in particular:
- a temperature (T) of a transistor (46) of the semiconductor circuit breaker (44),
- a temperature of a diode (48) of the semiconductor circuit breaker (44), said diode (48) being antiparallel connected to the transistor (46),
- a current strength of a current (Ic) flowing through the semiconductor circuit breaker (44),
- a voltage (Ud) dropping over the semiconductor circuit breaker (44) and/or
- an average value over time for one of the preceding variables.

5. Circuit arrangement according to one of the preceding claims, **characterised in that** the actuation device (78, 96, 106) is so designed as to automatically establish the parameter value as a function of an operating state of the semiconductor circuit breaker (44), in particular with reference to a characteristic curve (76).

6. Circuit arrangement according to one of the preceding claims, **characterised in that** the actuation device (42) is so designed as to receive the parameter value for a predetermined switching parameter (Uce,max, dIoff/dt, dUoff/dt, dIon/dt, dUon/dt) together with the switching signal via a control line (54).

7. Method for controlling a semiconductor circuit breaker (44) by means of a signal generating device (84, 104) for generating a switching signal and by means of an actuation device (42, 78, 96, 106) for generating a control voltage for the semiconductor circuit breaker (44), comprising the steps:
- determining an operating state (Ic, T, Ud) of the semiconductor circuit breaker (44) and establishing at least one parameter value of a switching parameter (Uce,max, dIoff/dt, dUoff/dt, dIon/dt, dUon/dt) of the actuation device (42, 78, 96, 106), by means of which a criterion for at least one operating variable (Uce,max, dIoff/dt, dUoff/dt, dIon/dt, dUon/dt) of the semiconductor circuit breaker (44) is established during a switching action of the semiconductor circuit breaker (44) ;
- generating the switching signal by means of the signal generating device (84, 104) and transmitting the switching signal to the actuation device (42, 78, 96, 106);
- receiving the switching signal by means of the actuation device (42, 78, 96, 106) and generating a control voltage at a control input (50) of the semiconductor circuit breaker (44) as a function of the switching signal, wherein a temporal profile of a voltage value of the control voltage is established in such a way that, during a switching action, the operating variable (Uce,max, dIoff/dt, dUoff/dt, dIon/dt, dUon/dt) satisfies the criterion which is predefined by the parameter value,
**characterised in that**
the actuation device (42, 78, 96, 106) is so designed as to receive a digital signal via a switching input (52) using a fault-tolerant transmission protocol and/or to transmit a digital signal via a measuring output (68) using a fault-tolerant transmission protocol, wherein an operating variable of the semiconductor circuit breaker (44), in particular a temperature (T) thereof, is determined on the basis of a numeric model (86) as a function of at least one other operating variable (Ta, i(t), u(t)).

8. Method according to claim 7, in which at least one of the following operating variables of the semiconductor circuit breaker (44) is measured for the purpose of determining the operating state:
- a temperature (T) of a transistor (46) of the semiconductor circuit breaker (44),
- a temperature of a diode (48) of the semiconductor circuit breaker (44), said diode (48) being antiparallel connected to the transistor (46),
- a current strength of a current (Ic) flowing through the semiconductor circuit breaker (44),
- a voltage (Ud) dropping over the semiconductor circuit breaker (44),
- an average value over time for one of the preceding variables.

9. Method according to claim 8, wherein by means of establishing the parameter value of a switching parameter (Uce,max, dIoff/dt, dUoff/dt, dIon/dt, dUon/dt), a desired value or a limit value for one of the following operating variables is predefined for a switching action:
- a voltage (Ud) dropping over a transistor (46) and/or a diode (48) of the semiconductor circuit breaker (44),
- a gradient (dUoff/dt, dUon/dt) of a temporal profile of this voltage (Ud),
- a gradient (dIoff/dt, dIon/dt) of a temporal profile of the current (Ic) to be switched or
- an average value over time for one of the preceding variables.

## Revendications

1. Montage de coupure d'un courant (Ic) en fonction d'un signal de coupure pouvant être donné à l'avance, comprenant :
- un disjoncteur (44) à semi-conducteur pour la coupure du courant (Ic) et
- un dispositif (42, 78, 96, 106) d'excitation, qui est conçu pour recevoir le signal de coupure et pour, en fonction du signal de coupure reçu, produire à une entrée (50) de commande du disjoncteur (44) à semi-conducteur une tension de commande ayant une courbe en fonction du temps par laquelle il est provoqué, que pendant une opération de coupure, au moins une grandeur (Uce, max, dI-off/dt, dUoff/dt, dIon/dt, dUon/dt) de fonctionnement déterminée à l'avance du disjoncteur (44) à semi-conducteur satisfasse un critère déterminé à l'avance, le critère étant prescrit par un paramètre (Uce, max, dI-off/dt, dUoff/dt, dIon/dt, dUon/dt) de coupure du dispositif (42, 78, 96, 106) d'excitation et une valeur du paramètre (Uce, max, dI-off/dt, dUoff/dt, dIon/dt, dUon/dt) de coupure pouvant être modifiée pendant un fonctionnement du montage,
**caractérisé en ce que**
le dispositif (42, 78, 96, 106) d'excitation est conçu pour recevoir par l'intermédiaire d'une entrée (52) de coupure un signal numérique sur la base d'un programme de transmission tolérant vis-à-vis d'une erreur et/ou pour émettre par l'intermédiaire d'une sortie (68) de mesure un signal numérique sur la base d'un programme de transmission tolérant vis-à-vis d'une erreur, une grandeur de fonctionnement du disjoncteur (44) à semi-conducteur, notamment sa température (T), étant déterminée sur la base d'un modèle (86) numérique en fonction d'au moins une autre grandeur (Ta, i(t), u(t)) de fonctionnement.

2. Montage suivant la revendication 1,
**caractérisé en ce que**
par rapport à au moins l'une des grandeurs de fonctionnement suivantes, un critère peut être donné à l'avance par fixation d'une valeur de paramètre :
- une tension (Uce, max) chutant aux bornes d'un transistor et/ou d'une diode du disjoncteur (4) à semi-conducteur,
- une pente (dUoff/dt, dUon/dt) d'une courbe en fonction du temps de cette tension,
- une pente (dUoff/dt, dUon/dt) d'une courbe en fonction du temps du courant (Ic) à couper et/ou
- une valeur moyenne en fonction du temps de l'une des grandeurs précédentes.

3. Montage suivant l'une des revendications 1 ou 2,
**caractérisé en ce que**
par la valeur de paramètre, il peut être donné à l'avance comme critère une valeur limite ou une valeur de consigne de la grandeur (Uce, max, dI-off/dt, dUoff/dt, dIon/dt, dUon/dt) de fonctionnement.

4. Montage suivant l'une des revendications précédentes,
**caractérisé en ce que**
par un dispositif (64, 66, 80, 82, 98, 100) de mesure pour relever au moins une grandeur (Ic, T, Ud) de fonctionnement, par laquelle un état de fonctionnement du disjoncteur (44) à semi-conducteur est décrit, notamment
- une température (T) d'un transistor (46) du disjoncteur (44) à semi-conducteur,
- une température d'une diode (48) montée tête bêche par rapport au transistor (46) du disjoncteur (44) à semi-conducteur,
- une intensité d'un courant (Ic) passant dans le disjoncteur (44) à semi-conducteur,
- une tension (Ud) chutant aux bornes du disjoncteur (44) à semi-conducteur et/ou
- une valeur moyenne en fonction du temps de l'une des grandeurs précédentes.

5. Montage suivant l'une des revendications précédentes,
**caractérisé en ce que**
le dispositif (78, 96, 106) d'excitation est conçu pour fixer automatiquement la valeur du paramètre en fonction d'un état de fonctionnement du disjoncteur (44) à semi-conducteur ,notamment sur la base d'une courbe (76) caractéristique.

6. Montage suivant l'une des revendications précédentes,
**caractérisé en ce que**
le dispositif (42) d'excitation est conçu pour recevoir, par l'intermédiaire d'une ligne (54) de commande ensemble avec le signal de coupure, la valeur de paramètre d'un paramètre (Uce, max, dI-off/dt, dUoff/dt, dIon/dt, dUon/dt) de coupure déterminé à l'avance.

7. Procédé de commande d'un disjoncteur (44) à semi-conducteur au moyen d'un dispositif (84, 104) donnant un signal pour la production d'un signal de coupure et au moyen d'un dispositif (42, 78, 96, 106) d'excitation pour la production d'une tension de commande du disjoncteur (44) à semi-conducteur, comprenant les stades :
- détermination d'un état (Ic, T, Ud) de fonctionnement du disjoncteur (44) à semi-conducteur et fixation d'au moins une valeur d'un paramètre (Uce, max, dI-off/dt, dUoff/dt, dIon/dt, dUon/dt) de coupure du dispositif (42, 78, 96, 106) d'excitation, par lequel, pendant une opération de coupure du disjoncteur (44) à semi-conducteur, un critère d'au moins une grandeur (Uce, max, dI-off/dt, dUoff/dt, dIon/dt, dUon/dt) de fonctionnement du disjoncteur (44) à semi-conducteur est fixée
- production du signal de coupure au moyen du dispositif (84, 104) donnant un signal et transmission du signal de coupure au dispositif (42, 78, 96, 106) d'excitation;
- réception du signal de coupure par le dispositif (42, 78, 96, 106) d'excitation et production d'une tension de commande à une entrée (50) de commande du disjoncteur (44) à semi-conducteur en fonction du signal de coupure, une courbe en fonction du temps d'une valeur de la tension de commande étant fixée de manière à ce que, pendant une opération de coupure, la grandeur (Uce, max, dI-off/dt, dUoff/dt, dIon/dt, dUon/dt) de fonctionnement satisfasse le critère donné à l'avance par la valeur du paramètre,
**caractérisé en ce que**
le dispositif (42, 78, 96, 106) d'excitation est conçu pour recevoir par l'intermédiaire d'une entrée (52) de coupure un signal numérique sur la base d'un programme de transmission tolérant vis-à-vis d'une erreur et/ou pour émettre par l'intermédiaire d'une sortie (68) de mesure un signal numérique sur la base d'un programme de transmission tolérant vis-à-vis d'une erreur, une grandeur de fonctionnement du disjoncteur (44) à semi-conducteur, notamment sa température (T), étant déterminée sur la base d'un modèle (86) numérique en fonction d'au moins une autre grandeur (Ta, i(t), u(t)) de fonctionnement.

8. Procédé suivant la revendication 7, dans lequel on mesure au moins l'une des grandeurs de fonctionnement suivantes du disjoncteur (44) à semi-conducteur pour déterminer l'état de fonctionnement :
- une température (T) d'un transistor (46) du disjoncteur (44) à semi-conducteur,
- une température d'une diode (48) montée tête bêche par rapport au transistor (46) du disjoncteur (44) à semi-conducteur,
- une intensité d'un courant (Ic) passant dans le disjoncteur (44) à semi-conducteur,
- une tension (Ud) chutant aux bornes du disjoncteur (44) à semi-conducteur et/ou
- une valeur moyenne en fonction du temps de l'une des grandeurs précédentes.

9. Procédé suivant la revendication 8,
dans lequel
par la fixation de la valeur d'un paramètre (Uce, max, dI-off/dt, dUoff/dt, dIon/dt, dUon/dt) de coupure on prescrit une valeur de consigne ou une valeur limite de l'une des grandeurs de fonctionnement suivantes d'une opération de coupure :
- une tension (Uce, max) chutant aux bornes d'un transistor et/ou d'une diode du disjoncteur (4) à semi-conducteur,
- une pente (dUoff/dt, dUon/dt) d'une courbe en fonction du temps de cette tension,
- une pente (dUoff/dt, dUon/dt) d'une courbe en fonction du temps du courant (Ic) à couper ou
- une valeur moyenne en fonction du temps de l'une des grandeurs précédentes.
